(19) **Europäisches Patentamt / European Patent Office / Office européen des brevets**

(11) **EP 3 424 874 B1**

(12) **FASCICULE DE BREVET EUROPEEN**

(45) Date de publication et mention
de la délivrance du brevet:
**30.09.2020 Bulletin 2020/40**

(51) Int Cl.:
***B81B 3/00*** *(2006.01)*

(21) Numéro de dépôt: **18187837.2**

(22) Date de dépôt: **24.02.2010**

(54) **DISPOSITIF CAPTEUR A BASE DE NANOFILS AVEC MASSE MOBILE**

SENSORVORRICHTUNG AUF DER BASIS VON NANODRÄHTEN MIT EINER MOBILEN MASSE

SENSOR DEVICE BASED ON NANOWIRES WITH MOBILE MASS

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **27.02.2009 FR 0951251**

(43) Date de publication de la demande:
**09.01.2019 Bulletin 2019/02**

(62) Numéro(s) de document de la (des) demande(s) initiale(s) en application de l'article 76 CBE:
**10154557.2 / 2 223 887**

(73) Titulaire: **Commissariat à l'énergie atomique et aux énergies alternatives**
**75015 Paris (FR)**

(72) Inventeurs:
• **DURAFFOURG, Laurent**
**38500 VOIRON (FR)**

• **ANDREUCCI, Philippe**
**38430 Moirans (FR)**
• **ERNST, Thomas**
**38210 Morette (FR)**
• **HENTZ, Sébastien**
**38000 Grenoble (FR)**

(74) Mandataire: **Brevalex**
**95, rue d'Amsterdam**
**75378 Paris Cedex 8 (FR)**

(56) Documents cités:
**WO-A2-2008/017090    US-A1- 2004 112 964**

• **RONG ZHU ET AL: "Design of a Hybrid Micro/Nano Cantilever-based Resonant Sensor and its Fabrication Method", NANO/MICRO ENGINEERED AND MOLECULAR SYSTEMS, 2006. NEMS '06. 1ST IEEE INTERNATIONAL CONFERENCE ON, IEEE, PI, 1 janvier 2006 (2006-01-01), pages 766-769, XP031063959, ISBN: 978-1-4244-0139-0**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE ET ART ANTÉRIEUR**

L'invention concerne la réalisation et la mise en œuvre de capteurs à base de nanofils. Elle trouve des applications dans des domaines variés, tel que celui des capteurs chimiques notamment en phase gazeuse ou en phase liquide ou celui des capteurs de force notamment inertiel ou moléculaire ou encore dans le domaine de la spectrométrie de masse.

Un nanofil possède un très faible diamètre (inférieur à <100 nm), un ratio surface/volume très favorable et est donc sensible à toute perturbation externe, par exemple par modulation de leur conductance électrique lorsque des atomes sont absorbés à sa surface. Les nanofils sont donc des candidats pour la mesure ultime de masse avec des précisions attendues proches du dalton ($1.67 \times 10^{-24}$ g).

Lorsqu'ils sont utilisés en tant qu'éléments mécaniques vibrants, leur sensibilité, qui est définie comme le rapport du décalage en fréquence induit par la masse ajoutée (par exemple par adsorption) à leur masse propre, est forte car cette dernière (masse propre) est très faible (1,7 ag pour un fil de 1 $\mu$m de long et un diamètre de 30 nm).

On connaît aussi une structure de capteur décrite dans le document WO2005/106417 utilisant une nanopoutre et on connaît en outre un dispositif à nanofil, décrit dans l'article de M. Roukes et. al., Nanoletters, Vol 8, no 6, p. 1756-1761 (2008). Le nanofil est mis en vibration par pot vibrant piézoélectrique externe puis par une excitation électrostatique. Le nanofil est excité au-delà de son amplitude critique, ce qui permet de générer dans le nanofil des contraintes et d'exploiter ainsi l'effet piézorésistif à l'ordre 2. Le nanofil est construit par croissance entre deux plots de silicium.

Dans le dispositif décrit dans cet article, le nanofil est à la fois le transducteur piézorésistif (le courant passe à travers le nanofil) et la masse d'épreuve (le mouvement de sa propre masse induit l'inertie).

L'effet piézorésistif observé est la variation de la résistance du nanofil en fonction de son propre mouvement de flexion.

Mais, dans ce type de système, l'effet piézorésistif est obtenu à l'ordre deux. C'est aussi le cas pour la structure de capteur décrite dans le document WO2005/106417. Ceci limite la sensibilité du capteur et complique le traitement de signal électrique qui correspond au double de la fréquence d'excitation. En effet, on montre que la variation relative de sa résistance $\Delta R/R$ est proportionnelle au carré de sa déflexion :

$$\frac{\Delta R}{R} = G\frac{\Delta L}{L} = G\varepsilon_L = G\frac{\pi^2}{4}\left(\frac{a}{L}\right)^2 \tag{1}$$

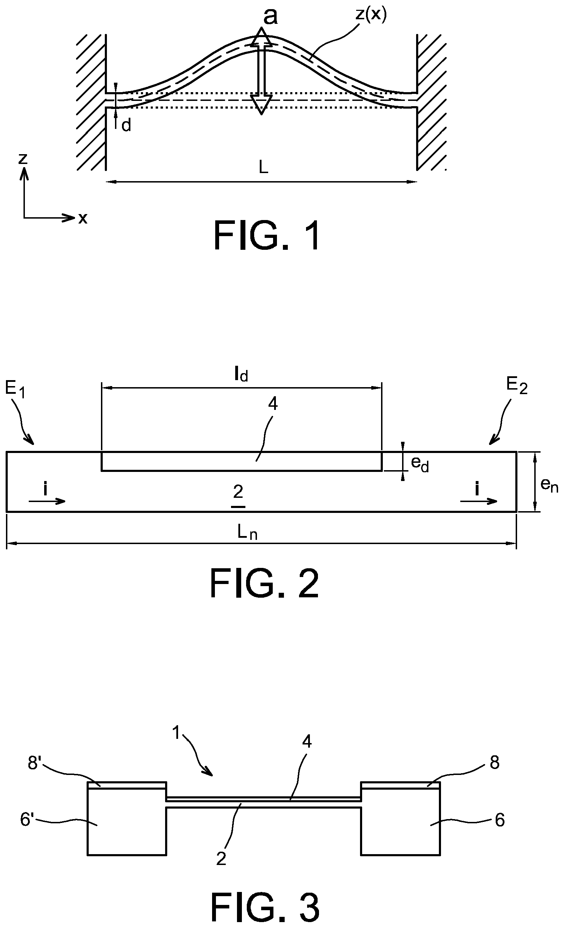

où G est le facteur de jauge caractérisant le phénomène piézorésistif. G dépend du matériau, de l'orientation cristalline et de la section du fil. L est la longueur du fil, représenté en figure 1. $\Delta L$ est sa variation de longueur. $\varepsilon_L$ est la déformée associée.

Un dispositif capteur, de type à nanofil, comportant au moins un nanofil et au moins une masse mobile fixée à l'une des extrémités du nanofil est divulgué dans le document WO 2008/017090 A2.

**EXPOSÉ DE L'INVENTION**

Un dispositif capteur selon l'invention, de type à nanofil, comporte au moins un nanofil, comportant une première zone, conductrice, et une deuxième zone, en matériau isolant, cette deuxième zone n'occupant pas toute l'épaisseur du nanofil. Un courant électrique peut circuler dans ce dernier depuis l'une de ses extrémités à l'autre.

La deuxième zone peut s'étendre sur une longueur inférieure à celle du nanofil.

Selon un mode de réalisation, la partie conductrice du nanofil est en matériau semiconducteur dopé, par exemple en matériau piezorésistif, ou en matériau métallique.

Un dispositif selon l'invention permet d'exploiter un effet piézorésistif à l'ordre 1, c'est-à-dire une variation de résistance du fil, lorsqu'il est soumis à une contrainte axiale, proportionnelle à l'allongement du fil. La contrainte axiale est proportionnelle au déplacement suivant la flèche du nanofil, ce qui correspond à un déplacement en flexion.

La partie conductrice du nanofil peut être en un matériau semi-conducteur dopé, tel que du Si dopé. Le semi-conducteur peut être dopé avec, par exemple, de l'arsenic, ou du bore, ou du phosphore.

La partie conductrice du nanofil peut être en un métal siliciuré (Si dans lequel on a diffusé du métal), par exemple en NiSi ou en WSi ou en PtSi.

Le matériau isolant peut être un matériau diélectrique ou un matériau semi-conducteur intrinsèque, par exemple du silicium ou un alliage de silicium et de Germanium (SiGe), non dopés.

La zone diélectrique est par exemple en nitrure de silicium ou d'aluminium ou en oxyde de silicium.

En variante, un dispositif selon ce mode de réalisation comporte :

- une zone diélectrique en SiGe non dopé, et une zone conductrice en Si dopé,
- ou une zone diélectrique en Si non dopé, et une zone conductrice en SiGe dopé.

Si le silicium est dopé, il est piézorésistif et présente un facteur de jauge G élevé, par exemple d'environ 1000 alors que si le silicium est siliciuré, il devient métallique et son facteur G est très faible, par exemple d'environ 2.

Une extrémité du nanofil peut être fixée dans une zone de maintien, fixe, cette zone de maintien comportant en outre une zone de contact électrique. Eventuellement, chacune des deux extrémités est ainsi fixée.

Au moins une zone de contact électrique peut être réalisée dans le même matériau conducteur que la première zone, conductrice, du nanofil. Une ou des zone(s) de contact peuvent être réalisées en matériau semiconducteur, plus ou moins dopé pour lui conférer des propriétés conductrices, par exemple avec un dopage compris entre $10^{15}$ cm$^{-3}$ et $10^{19}$ cm$^{-3}$ ou même supérieur à $10^{19}$ cm$^{-3}$ ou supérieur ou égal à $10^{20}$ cm$^{-3}$. (le matériau semiconducteur peut donc être dégénéré du fait de ce fort dopage). C'est par exemple un dopage avec de l'arsenic, ou, préférentiellement, du bore, ou du phosphore, éventuellement avec un gradient dans l'épaisseur. Un dispositif selon l'invention permet donc une amélioration des prises ou zones de contact ou d'accès, et donc une résistance d'accès très faible.

En variante, une masse mobile peut être fixée à l'une des extrémités du nanofil.

Un dispositif selon l'invention peut comporter au moins deux nanofils, tous deux fixés à la masse mobile.

Selon un mode particulier de réalisation l'autre extrémité de chaque nanofil peut être fixée à une zone commune de maintien, fixe.

Un dispositif selon l'invention peut en outre comporter des moyens de transduction traduisant, en signal électrique, des mouvements d'au moins un nanofil ou d'une masse fixée à l'une des extrémités du nanofil.

Des moyens d'actionnement d'un nanofil selon l'invention peuvent être prévus, par exemple de type électrostatique ou de type thermo-élastique ou encore de type magnétique.

## BRÈVE DESCRIPTION DES DESSINS

- La figure 1 représente une vue schématique d'un fil en flexion se déplaçant d'une amplitude a,
- la figure 2 représente un nanofil selon l'invention,
- la figure 3, et les figures 4A - 8B, représentent divers structures de nanofil selon l'invention,
- les figures 9A à 9C représentent un dispositif comportant plusieurs nanofil selon l'invention, disposés autour d'une masse vibrante hors de son plan,
- les figures 10A et 10B représentent un nanofil métallique selon l'invention, avec une zone isolante en son centre,
- les figures 11A et 11B représentent un nanofil métallique selon l'invention, avec une couche isolante proche des encastrements,
- les figures 12A et 12B représentent un dispositif comportant deux nanofils selon l'invention, disposés de manière à réaliser deux bras de flexion attachés à une masse vibrante hors de son plan,
- les figures 13 - 15 représentent des dispositifs à réseaux de nanofils selon l'invention,
- les figures 16 - 18 représentent des moyens pour mesurer une variation de résistance dans un nanofil selon l'invention,
- la figure 19 est un schéma d'une jauge piézorésistive avec les axes principaux (N, T) associés,
- la figure 20 est un schéma représentant un moment fléchissant et une contrainte axiale induite dans une section d'un nanofil,
- les figures 21A - 21C représentent un nanofil selon l'invention, et le calcul de la position de la fibre neutre c à partir des positions des fibres neutres des sections de chaque couche,
- les figures 22A à 22L et 23A - 23E sont des étapes de réalisation de différents dispositifs selon l'invention,
- les figures 24A à 24E sont d'autres étapes de réalisation d'un dispositif selon l'invention.

## EXPOSÉ DETAILLE DE MODES DE REALISATION DE L'INVENTION

Une structure de dispositif selon l'invention est illustrée en figure 2. Cette structure comporte un nanofil 1, qui comporte lui-même deux parties ou zones 2, 4 ayant des conductivités très différentes.

Deux types de zone conductrice 2, et donc deux types de transductions, peuvent être exploitées. On va donc successivement décrire ces deux modes de réalisation.

Dans un premier mode de réalisation de l'invention, l'une de ces zones, ici la zone 2, est piezorésistive et conductrice, tandis que la zone 4 est isolante ou diélectrique. Ce premier type de dispositif selon l'invention met donc en œuvre la piézorésistivité intrinsèque à un nanofil qui est par exemple constitué d'un matériau semi conducteur dopé. Le facteur de jauge G (longitudinal) est alors élevé, de l'ordre de 1000, ou plus.

La zone conductrice 2 est par exemple réalisée en un matériau semi-conducteur, tel que du silicium (mais d'autres semi-conducteurs peuvent être utilisés), qui peut être plus ou moins dopé pour lui conférer des propriétés conductrices.

Le dopage peut-être plus ou moins important, par exemple compris entre $10^{15}$ cm$^{-3}$ et $10^{19}$ cm$^{-3}$. C'est par exemple un dopage avec de l'arsenic, ou, préférentiellement, du bore, ou du phosphore, éventuellement avec un gradient dans l'épaisseur. Un tel dopage peut être réalisé lors de l'épitaxie d'une couche de matériau semi-conducteur dans laquelle le nanofil sera réalisé. En variante, il peut être réalisé par d'autres techniques, par implantation par exemple.

La zone isolante 4 peut, quant à elle, être en un nitrure ou en un oxyde, par exemple elle est en SiN, ou en un oxyde, par exemple en Si02. Avantageusement, la couche isolante est en AlN. En variante, c'est une pluralité de couches simples diélectriques.

En variante, une couche peut être graduellement modifiée, par exemple par un gradient de dopage dans l'épaisseur, par implantation en une fois ou par une succession d'étapes d'implantation. Ce gradient peut être réalisé par exemple par une implantation suivie d'un recuit. On peut réaliser également une implantation utilisant des étapes successives d'implantation à des profondeurs différentes de pénétration.

Ces exemples de matériaux diélectriques et de matériaux piézorésistifs conducteurs peuvent être employés dans les divers exemples ci-dessous du premier mode de réalisation selon l'invention.

Dans un autre mode de réalisation, l'une de ces zones, ici la zone 2, est métallique tandis que la zone 4 est isolante ou diélectrique. On favorise ainsi une transduction dite « piézorésistive » due à l'allongement du métal, à faible facteur de jauge (longitudinal). Les nanofils métalliques sont beaucoup moins résistifs que ceux en matériau semi-conducteur. Le bruit de Johnson associé est donc plus faible et permet d'atteindre des résolutions plus faibles que dans le premier mode de réalisation. En contre partie, la sensibilité (pente de la réponse) est plus faible que dans le cas piézorésisitif obtenu avec un semi-conducteur.

Un nanofil de ce deuxième mode de réalisation peut être réalisé par exemple à partir d'un fil en un siliciure tel que NiSi, ou WSi2, ou PtSi. Il est éventuellement possible de doper par implantation jusqu'à l'amorphisation un nanofil en matériau semi-conducteur ou de réaliser un dopage pendant une épitaxie d'une couche dans laquelle le nanofil sera créé (cette solution permet de générer un gradient de dopage).

Un matériau isolant pour la zone 4 de ce deuxième mode de réalisation est par exemple le silicium intrinsèque, ou un isolant tel que SiN ou SiO$_2$.

Là encore, ces exemples de matériaux diélectriques et de matériaux piézorésistifs conducteurs peuvent être employés dans les divers exemples ci-dessous du deuxième mode de réalisation selon l'invention.

Quel que soit le mode de réalisation envisagé, un dispositif selon l'invention met en œuvre la circulation d'un courant i sur toute la longueur du nanofil. Or, la résistance de la portion conductrice varie en fonction de sa déformation. Le nanofil est donc utilisé à la fois comme masse d'épreuve (il constitue la partie mobile) et comme élément de jauge (ce sont ses propriétés électriques que l'on mesure). On peut en particulier mesurer la variation de courant i dans le nanofil, celui-ci étant sous tension constante, lorsque ce nanofil est soumis à une déformation.

Sur la figure 2, on peut également voir les caractéristiques géométriques d'un nanofil selon l'invention. La longueur totale du nanofil est désignée par $L_n$ et son épaisseur ou son diamètre par $e_n$, tandis que la longueur et l'épaisseur (ou le diamètre) de la zone diélectrique 4 sont désignées respectivement par les lettres $l_d$ et $e_d$.

L'épaisseur ou le diamètre $e_n$ est inférieur à 50 nm, ou à quelques dizaines de nm, elle ou il est par exemple de 40 nm. Dans un nanofil selon l'invention, on a en outre au moins la condition suivante (C1): $e_d < e_n$. Autrement dit, la zone diélectrique n'occupe pas toute l'épaisseur du nanofil, et un courant i peut circuler dans ce dernier depuis l'une de ses extrémités $E_1$ à l'autre extrémité $E_2$. $e_d$ est par exemple égal à 10 nm. Pour un effet optimal, on considère par exemple une épaisseur d'isolant de 40 nm et une épaisseur de Si dopé de 10 nm, ou plus généralement une épaisseur d'isolant supérieure à celle du Si dopé ; encore selon un autre exemple, on considère une épaisseur de Si de 40 nm et une épaisseur de métal de 10 nm, ou plus généralement une épaisseur de Si supérieure à celle du métal.

S'il y a plusieurs zones diélectriques 4 le long du fil, chacune respecte cette condition C1. Dans certains modes de réalisation, on a en outre la condition (C2) suivante : $l_d < L_n$, ce qui signifie que la zone diélectrique 4 n'a pas une extension longitudinale suivant toute la longueur $L_n$ du nanofil.

La zone 4, isolante ou diélectrique, peut donc être localisée dans le nanofil. Cette localisation permet en particulier de minimiser la résistance globale du fil, afin d'optimiser le rapport signal à bruit : pour un matériau isolant donné, on peut sélectionner les dimensions $l_d$ et $e_d$ de la zone 4 pour adapter la résistance du fil.

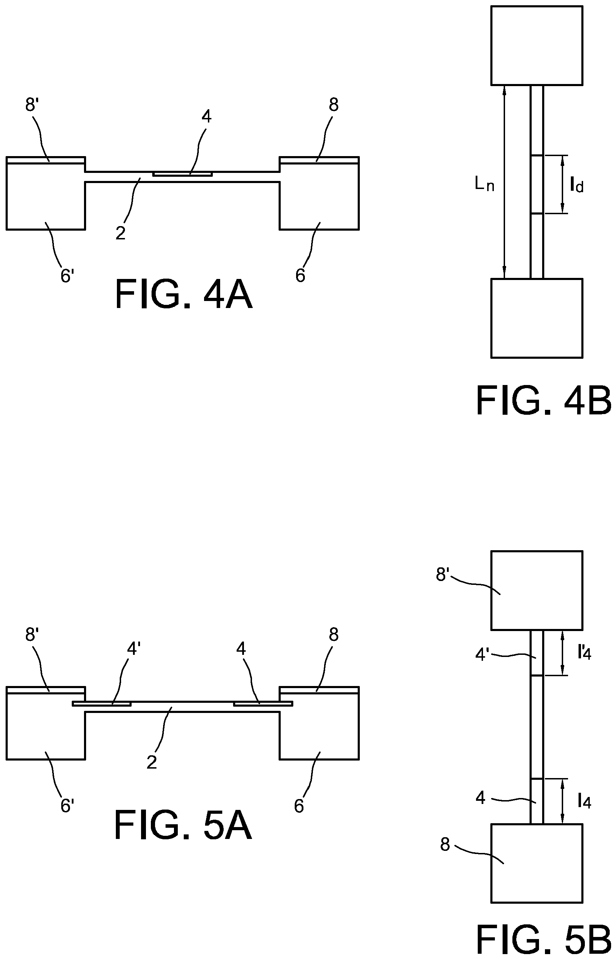

La figure 3 représente un dispositif selon l'invention du premier type mentionné ci-dessus, avec zone conductrice piézorésistive. D'autres exemples de ce mode de réalisation sont décrits en liaison avec les figures 4A - 9B.

Dans l'exemple de la figure 3, ce nanofil 1 satisfait à la première des deux conditions géométriques ci-dessus : la zone diélectrique 4 s'étend tout le long du nanofil, mais sur une épaisseur limitée de celui-ci. Le nanofil est suspendu entre deux plots ou zones support ou zones d'encastrement 6,6'. Un contact électrique 8, 8' est prévu sur chacun de ces plots. Dans cet exemple de réalisation, comme dans les autres, ceux-ci sont réalisés par exemple sur une zone dopée de matériau semi-conducteur, puis siliciurée et finalement métallisée. Sur cette figure, comme sur les autres, peuvent être ajoutés des moyens pour appliquer une tension électrique de fonctionnement entre les deux extrémités du fil et des moyens pour mesurer une variation de courant dans le fil, due à une contrainte appliquée à ce dernier. Ces moyens ne sont pas représentés sur les figures.

Les figures 4A et 4B représentent un nanofil 1 en silicium ayant en son centre une couche 4 de diélectrique, qui est cette fois localisée. Les références 8 et 8' désignent là encore des contacts électriques. Dans cet exemple, il est satisfait aux deux conditions (C1) et (C2) ci-dessus : la zone diélectrique 4 s'étend sur une partie seulement de la longueur du nanofil, et sur une épaisseur seulement de celui-ci.

La variante des figures 5A et 5B représente un dispositif dans lequel une couche isolante 4, 4' est placée à proximité de chaque encastrement 6, 6' du nanofil. La longueur totale des couches isolantes est inférieure à la longueur du nanofil (condition C2 ci-dessus), l'épaisseur de chacune d'entre elle est également inférieure à l'épaisseur du nanofil (condition C1). Les contacts électriques sont encore désignés par les références 8, 8'.

Cette variante est plus avantageuse que la précédente car les contraintes appliquées au fil sont maximales à ses extrémités, proches des zones d'encastrement 6, 6'. Le signal électrique est donc d'autant plus fort dans ce type de structure.

Afin de diminuer la valeur de la résistance des contacts 6, 6', il est possible de siliciurer et/ou doper les ancrages et éventuellement les zones de nanofils proches des ancrages qui contribuent alors aux contacts. Il est également possible d'alterner les couches. Ainsi sont représentés :

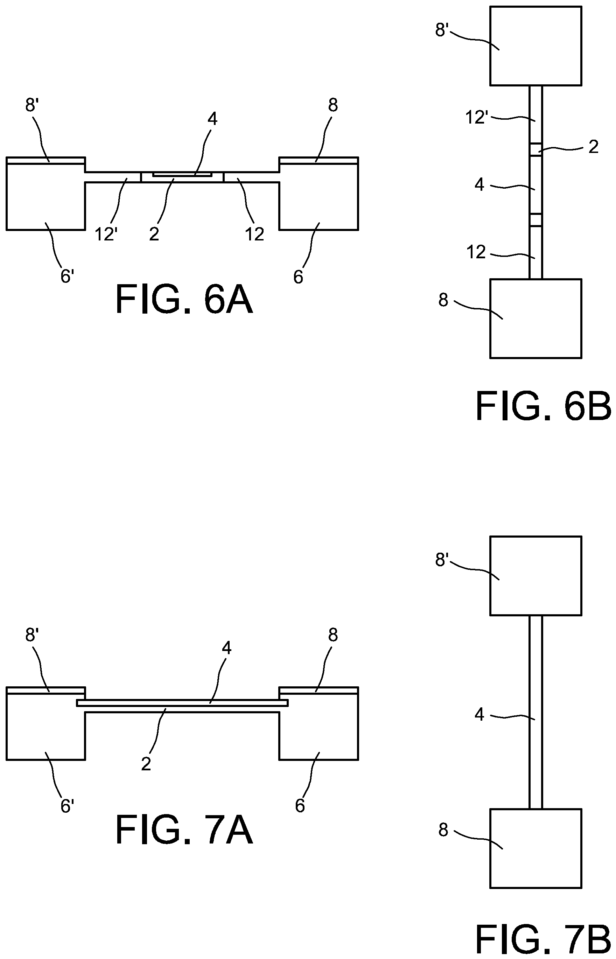

- en figures 6A, 6B, un nanofil 1 en silicium ayant en son centre une couche 4 de diélectrique qui satisfait aux deux conditions C1 et C2 ci dessus. On voit sur cet exemple que le nanofil comporte une portion centrale 2 en matériau piézorésistif et une zone 4 diélectrique. Les portions latérales 12, 12' du fil sont réalisées par exemple en un siliciure, tel que du NiSi ; elles forment des prolongements de chacune des zones conductrices 8, 8'. Autrement dit, ces dernières débordent de chaque plot pour former une partie du nanofil 1. Cette configuration permet d'améliorer fortement les contacts ohmiques entre les extrémités du fil et chacune des zones conductrices 8, 8' ; plus généralement, et comme déjà indiqué, une ou des zone(s) de contact peuvent être réalisées en matériau semiconducteur, plus ou moins dopé pour lui conférer des propriétés conductrices, par exemple avec un dopage compris entre $10^{15}$ cm$^{-3}$ et $10^{19}$ cm$^{-3}$ ou même supérieur à $10^{19}$ cm$^{-3}$ ou supérieur ou égal à $10^{20}$ cm$^{-3}$. (le matériau semiconducteur peut donc être dégénéré du fait de ce fort dopage). C'est par exemple un dopage avec de l'arsenic, ou, préférentiellement, du bore, ou du phosphore, éventuellement avec un gradient dans l'épaisseur. Un dispositif selon l'invention permet donc une amélioration des prises ou zones de contact ou d'accès, et donc une résistance d'accès très faible,

- en figures 7A, 7B, un nanofil en silicium 2 dopé avec une couche 4 de SiGe non dopée, à comportement isolant car présentant une très forte résistivité (cas du SiGe non dopé (intrinsèque) de haute résistivité, ou SiGe « HR »). Une telle couche 4 en SiGe peut être obtenue par exemple par épitaxie. Cette couche 4 a une longueur identique à celle du nanofil, mais son épaisseur est inférieure à celle du nanofil, conformément à la condition C1 indiquée ci-dessus,

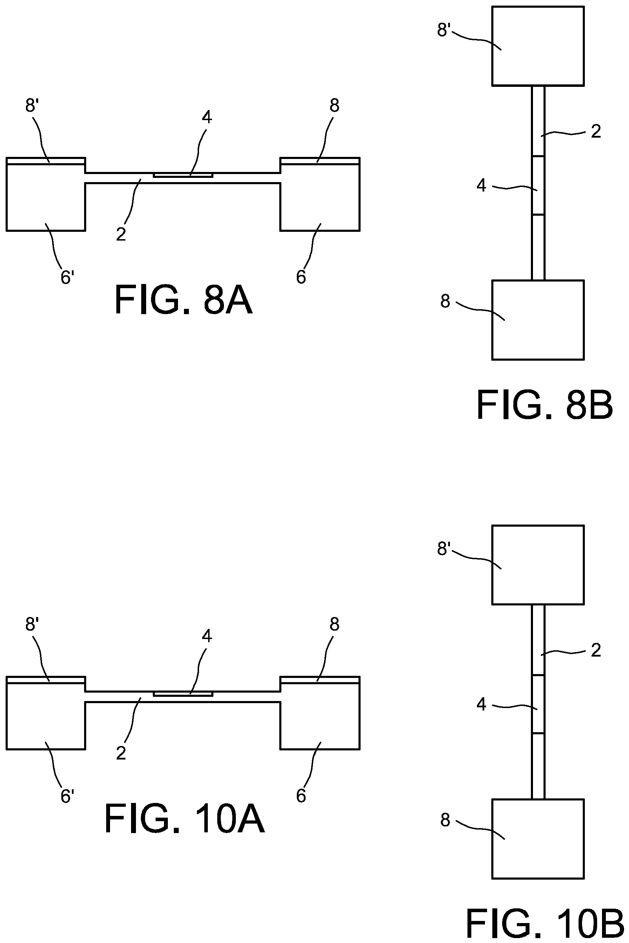

- en figures 8A, 8B, un nanofil en silicium 2 (ou en un autre matériau semi-conducteur dopé) avec une couche 4 de SiGe non dopée et localisée (au centre du nanofil dans l'exemple). Une telle couche 4 en SiGe peut être obtenue par exemple par épitaxie. Cette fois, cette couche 4 a une longueur inférieure à celle du nanofil, conformément à la condition C2 indiquée ci-dessus et son épaisseur est inférieure à celle du nanofil, conformément à la condition C1 indiquée ci-dessus.

Dans le cas des figures 7A, 7B, 8A - 8B, les fonctions des deux couches, respectivement en Si et en SiGe, peuvent être inversées. On peut, en effet, doper le SiGe pour le rendre conducteur, et ne pas doper le silicium pour l'utiliser en tant que matériau diélectrique (il s'agit de Si « HR »).

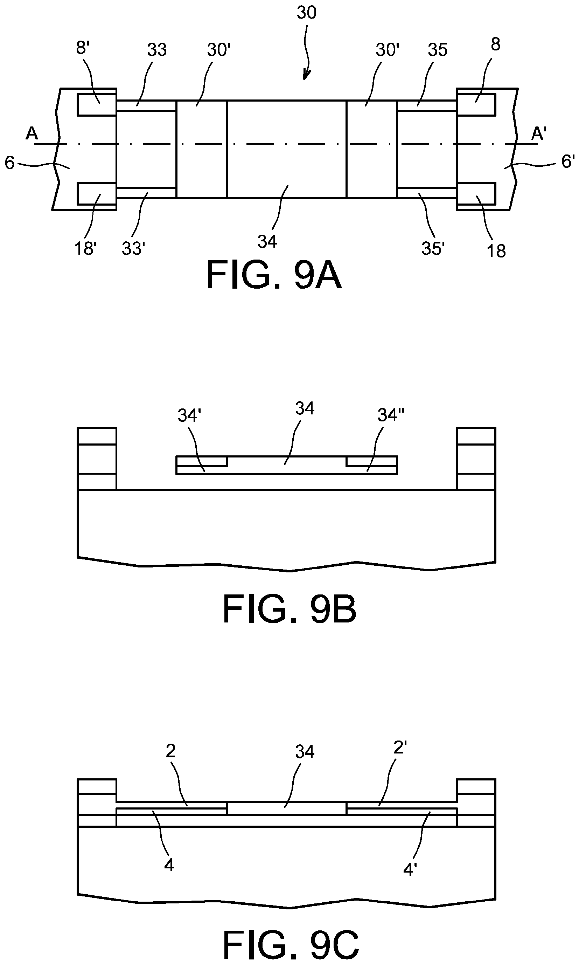

Une structure de nanofil selon l'invention, selon les figures 5A - 9B, peut être utilisée dans une structure plus complexe comportant une masse telle que celle des figures 9A - 9C.

Les figures 9B et 9C sont des vues en coupe selon les plans AA' et BB' de la figure 9A.

Cette structure comporte une partie centrale 30, formant une masse vibrante hors de son plan. Dans cet exemple, elle est, en vue de dessus, de forme sensiblement rectangulaire reliée à chacune des deux zones d'encastrement 6, 6' par deux bras 33, 33', 35, 35'.

D'autres formes en vue de dessus sont possibles, par exemple circulaire ou elliptique, là encore avec des bras.

Chaque bras est en fait constitué d'un nanofil selon la présente invention. Une extrémité de chaque nanofil est reliée à la partie fixe 6, 6' du dispositif, par des zones conductrices 8, 8', 18, 18', comme dans les exemples précédents.

La masse 30 contient elle-même une portion diélectrique 34, sur toute l'épaisseur de la masse, et qui sépare le dispositif en deux parties 30', 30", chacune de ces parties formant une zone de mesure avec les deux nanofils 33, 33' et 35, 35' qui lui sont reliés. Le reste de la masse 30 est en matériau conducteur. On voit sur la figure 9C que, dans la partie centrale, la portion diélectrique 34 se prolonge par des zones diélectriques 34', 34" d'épaisseur inférieure à la zone 34 qui peuvent être disposées en continuité des zones diélectriques 4, 4' des nanofils. Sur la figure 9C apparaît la structure de chacun des deux nanofils 33',35' de la figure 9A : chacun de ces deux nanofils comporte une couche diélectrique 4, 4' et une couche conductrice 2,2'.

Plus généralement, un ou plusieurs nanofils peuvent être associés ou reliés à une ou des masses par exemple selon un réseau. Cela permet d'augmenter la surface de capture pour des applications de mesure de masse ou d'augmenter la masse inertielle dans le cas de capteur de force inertiel.

Dans un nanofil selon l'invention, des contraintes internes peuvent apparaître, du fait de différences entre les paramètres de mailles du conducteur 2 et du diélectrique 4 et du fait de la différence entre les coefficients de dilation thermique de chacun de ces matériaux. Ces contraintes peuvent être contrôlées, afin d'obtenir des nanofils en tension. Ce contrôle peut être réalisé par exemple en contrôlant la ou les températures de dépôt, et en maîtrisant les épaisseurs relatives de différentes couches. Un nanofil selon l'invention peut donc offrir une rigidité plus élevée et une fréquence de résonance plus élevée qu'un nanofil réalisé uniquement en silicium. Ceci s'applique de manière générale, à un dispositif quelconque selon l'invention.

Le second type de dispositif selon l'invention met en œuvre un matériau 2 métallique, de préférence à faible facteur de jauge G (environ 2).

En figures 10A et 10B est représenté un nanofil métallique dont le centre 4 est en un matériau isolant, par exemple en silicium intrinsèque, ou en un isolant tel que SiN. Dans cet exemple, il est satisfait aux deux conditions (C1) et (C2) ci-dessus : la zone diélectrique s'étend sur une partie seulement de la longueur du nanofil, et sur une épaisseur seulement de celui-ci.

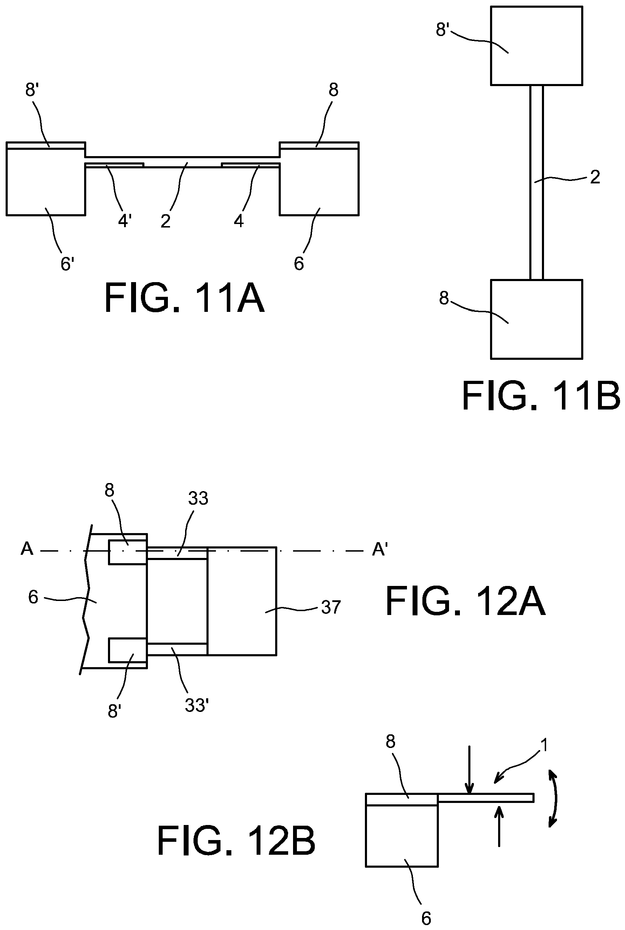

La variante des figures 11A et 11B représente un dispositif dans lequel le nanofil est partiellement isolant dans son épaisseur, par nitruration, dans une zone 4, 4' proche des encastrements 6, 6'. Les contacts électriques sont encore désignés par les références 8, 8' .

La structure d'un dispositif selon l'invention peut être plus complexe. Elle peut avoir la forme de celle qui serait obtenue selon les figures 9A-9C en y remplaçant toute référence à une partie piézorésistive par une partie métallique. La masse 30 joue encore le rôle de masse vibrante.

D'autres structures mettant en œuvre un dispositif avec nanofil dissymétrique selon l'invention peuvent être réalisées, qu'il s'agisse de nanofils selon l'un quelconque des modes de réalisation présentés ci-dessus.

C'est par exemple le cas de la structure des figures 12A - 12B, avec deux nanofils encastrés dans un plot 6, l'autre extrémité de chaque nanofil étant reliée à une masse 37. Cette masse 37 permet de réaliser une boucle de courant. Elle est donc au moins en partie conductrice. Le reste de la masse est généralement, par construction, dans les matériaux du nanofil car réalisé en même temps que celui ci. A chaque nanofil est associé une zone 8, 8' de contact dans le plot 6. L'ensemble présente une forme de U comme le montre la figure 12A.

On peut mettre en réseau des dispositifs selon l'invention qui ont été décrits plus haut.

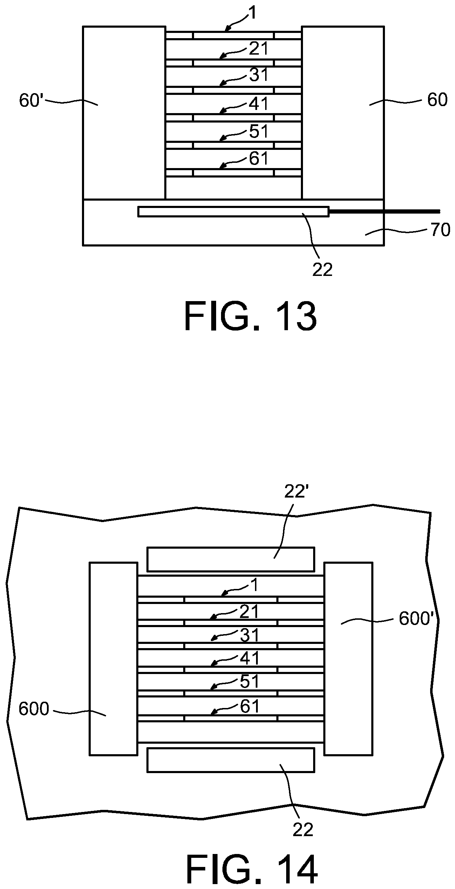

Un tel réseau peut prendre différentes formes, à pas variables ou à pas fixes, comme ceci va être expliqué en liaison avec les figures 13 à 15.

Sur chacune de ces figures, un dispositif comporte une pluralité de nanofils 1, 21, 31,.... selon l'invention, disposés parallèles entre eux, chacune des deux extrémités de chaque nanofil étant reliée à un plot 60, 60' ou à une partie d'un substrat. Le courant circulant dans les fils entre par le plot 60 et ressort par le plot 60'.

Chacun de ces dispositifs comporte au moins une électrode de contrôle 22, 22' parallèle aux nanofils.

Le réseau représenté en figure 13 est de type vertical, c'est-à-dire perpendiculaire au plan d'une plaquette ou d'un substrat 70 formant support.

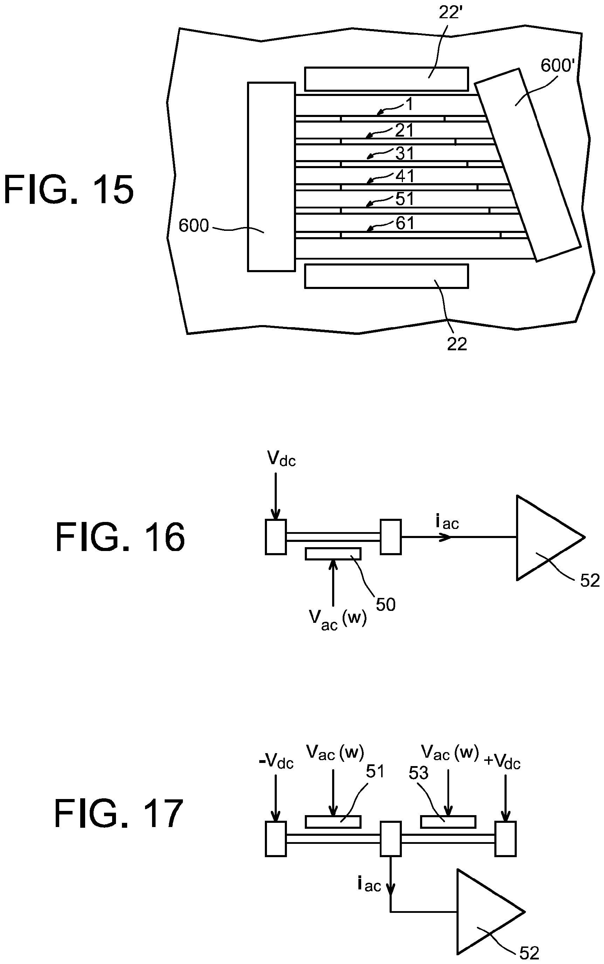

Le réseau représenté en figures 14 et 15 est de type horizontal, c'est-à-dire que les nanofils forment un réseau bidimensionnel situés dans le plan d'une plaquette ou d'un substrat 20, et dans laquelle ou lequel ils peuvent avoir été formés. Les références 22, 22' désignent deux électrodes de contrôle, disposées de part et d'autre du réseau de nanofils, parallèlement à ceux ci. Le courant circulant dans les fils entre par la zone 600 et ressort par la zone 600'.

Dans la variante du réseau représenté en figure 15, les nanofils sont de longueurs croissantes en fonction d'une direction perpendiculaire aux nanofils. On peut alors adresser individuellement chaque nanofil car chacun d'eux a une fréquence différente de celle des autres nanofils. Chaque nanofil peut détecter des espèces chimiques différentes par fonctionnalisation sélective. Chacune des espèce correspondra à une fréquence donnée.

Des moyens d'actionnement d'un nanofil selon l'invention comportent par exemple des moyens de type électrostatique. En variante, les moyens d'actionnement peuvent comporter des moyens de type thermoélastique ou de type magnétique ou tout autre moyen. De tels moyens permettent de donner au nanofil un mouvement suivant une direction perpendiculaire à sa direction d'extension.

L'actionnement électrostatique utilise la force électrostatique générée entre l'électrode 22 (ou 22') et le ou les nanofils par application d'une différence de potentiel.

L'actionnement thermoélastique est utilisable quand les deux couches (métallique et isolante) sont de même longueur, égale à celle du nanofil. Ce type d'actionnement exploite l'effet d'échauffement dans chacune des couches. Les couches étant de natures différentes, les dilatations sont différentes, ce qui génère un moment de flexion et donc un mouvement du nanofil.

Un dispositif selon l'invention peut mettre en œuvre des moyens de lecture de la variation de résistance du ou des nanofils. Des exemples de tels moyens vont être donnés en figures 16 - 18.

La variation de résistance aux bornes du (ou des) nanofil(s) peut être mesurée directement à travers la modulation du courant I qui le traverse, à tension de lecture constante. C'est par exemple le cas dans le schéma de la figure 16 : une tension constante $V_{dc}$ est appliquée aux bornes du nanofil. La référence 50 symbolise une électrode d'excitation à laquelle est appliquée une tension alternative $V_{ac}$. Le signal de sortie, un courant $i_{ac}$, est relié à un amplificateur 52.

Le schéma de la figure 17 représente une mesure directe avec un demi-pont. Le nanofil est sous une tension constante $V_{dc}$. Les électrodes 51 et 53 permettent d'appliquer à l'une des parties des fils une tension alternative de fréquence ω. Le courant alternatif iac qui sort, prélevé entre les deux parties du pont est envoyé à un amplificateur 52.

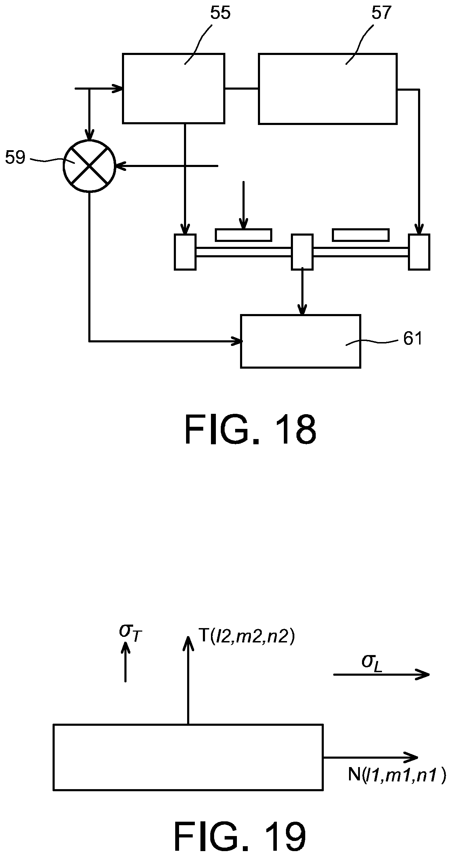

Une technique d'hétérodynage, représentée schématiquement en figure 18, permet de ramener la mesure de résistance des hautes fréquences vers les basses fréquences. Cette technique est aussi bien utilisable sur une mesure directe que sur une mesure différentielle par pont. Pour cette technique on peut se référer à I. Bargatin et al. « Applied Physics Letters », vol. 86, 133109 (2005).

Dans ces montages, les tensions alternatives peuvent être générées avec des oscillateurs locaux. Le système de lecture peut être intégré (structuré sur la même puce) ou placé sur un ASIC externe.

Dans un dispositif selon l'invention, La transduction (la création d'un courant par le mouvement du nanofil) s'effectue à travers le nanofil, celui-ci est donc utilisé à la fois comme masse d'épreuve (partie mobile) et comme élément de jauge pour réaliser la conversion piézorésistive souhaitée.

On montre que la variation relative de la résistance du nanofil devient alors proportionnelle à l'amplitude du mouvement ; en reprenant les notations de l'équation (1) :

$$\frac{dR}{R} = G\varepsilon_L \approx \frac{G\pi t_1}{2z}\sin(\frac{2\pi z}{L})\left(\frac{a}{L}\right) \qquad (2)$$

Un dispositif selon l'invention permet donc de connaître la variation de résistance ΔR, liée à la variation de contrainte (σ) induite par la vibration du nanofil, car ΔR est proportionnelle à la contrainte.

D'une manière générale, une résistance formée par une structure, en forme de nanofil, ayant à la fois des propriétés conductrices et des propriétés élastiques, varie en fonction d'une contrainte axiale comme suit :

$$\frac{dR}{R} = \frac{d\rho}{\rho} + \frac{dL}{L} + \frac{dS}{S} = \frac{d\rho}{\rho} + \varepsilon_L(1+2v) \qquad (3)$$

où ρ est la résistivité du milieu constitué par le barreau, $\varepsilon_L$ est l'allongement relatif du barreau dont S et L sont respectivement la longueur et la section. υ est le coefficient de Poisson.

Le premier terme (dρ/ρ) correspond à l'effet piézorésisitif à proprement parler, alors que le second ($\varepsilon_L$ (1+2v)) correspond à un effet purement géométrique.

Dans le cas d'un semi-conducteur comme le silicium, le second terme est de plusieurs ordres de grandeur inférieur au premier.

La piézorésistivité est un phénomène physique qui relie une variation relative de résistivité $\dfrac{d\rho}{\rho}$ à une contrainte appliquée au matériau piezorésistif, qui est ici un nanofil. Cette relation peut s'exprimer comme suit :

$$\frac{d\rho}{\rho} = \Pi_L\sigma_L + \Pi_T\sigma_T \qquad (2),$$

avec :

$$\Pi_{L} = \Pi_{11} - 2(\Pi_{11} - \Pi_{12} - \Pi_{44})(l_1^2.m_1^2 + l_1^2.n_1^2 + m_1^2.n_1^2)$$

$$\Pi_{T} = \Pi_{12} + (\Pi_{11} - \Pi_{12} - \Pi_{44})(l_1^2 l_2^2 + m_1^2.m_2^2 + n_1^2.n_2^2)$$

$\Pi_{ij}$ sont les éléments du tenseur de piézorésistivité exprimés selon les axes cristallins principaux du semi-conducteur. $\Pi_L$ et $\Pi_T$ sont respectivement le coefficient piézorésistif longitudinal et le coefficient piézorésistif transversal exprimés dans un repère principal (N, T) du nanofil (voir figure 19), N étant dans le sens de la direction du nanofil, T étant dans une direction transverse. $\sigma_L$ et $\sigma_T$ sont respectivement les contraintes longitudinales et transverses appliquées, comme illustré sur la figure 19.

Dans le cas d'un nanofil orienté selon l'axe <110>, la variation de résistance se réduit à :

$$\frac{dR}{R} = \frac{d\rho}{\rho} = \frac{\Pi_{44}}{2}\sigma_L \qquad (3)$$

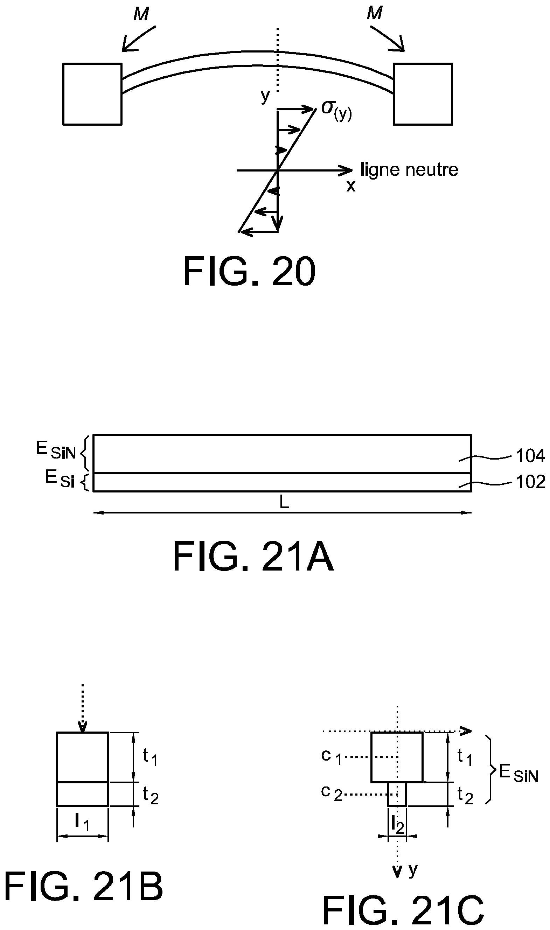

On prend d'abord le cas d'un nanofil homogène. Ce cas peut être traité comme une poutre de section circulaire. Ce fil est soumis à une contrainte, du fait de son passage à une position, illustré en figure 20, dans laquelle une partie du fil est amenée à l'écart de la position qu'elle occupe au repos (c'est à dire sans contrainte extérieure appliquée). Les contraintes longitudinales (axiales) induites par cette flexion s'expriment aisément en fonction du moment fléchissant :

$$\sigma_L = \frac{My}{I} \qquad (4)$$

I est le moment quadratique, M le moment fléchissant représenté en figure 20, y est l'ordonnée, en prenant la fibre neutre, le long de laquelle les contraintes sont nulles (ligne pointillée sur la figure 20) comme origine.

La contrainte moyenne sur la section du nanofil est nulle.

On prend maintenant le cas d'un nanofil non homogène, comme illustré en figure 21A de section rectangulaire composé d'une partie 102 en silicium faiblement dopé, d'épaisseur $t_2$ (par exemple le dopage est d'environ $10^{15}$ cm$^{-3}$ à $10^{19}$ cm$^{-3}$) et d'une partie 104 nitrurée SiN d'épaisseur $t_1$ piezorésistif.

La partie nitrurée 104 a ici une épaisseur $t_1$ plus importante que la partie 102 en silicium (épaisseur $t_2$) afin de concentrer la contrainte. En cas limite, l'épaisseur de la couche de Si devient négligeable devant celle de SiN, et la contrainte dans le Si est alors maximale et égale à la contrainte calculée sur la fibre externe de la couche SiN. Dans un cas plus général ($t_2$ non négligeable devant $t_1$), on détermine la position de la fibre neutre. Celle-ci dépend non seulement des épaisseurs mais aussi des modules d'Young respectifs ($E_{Si}$=160 GPa selon <110> et $E_{SiN}$=230 GPa) .

Les figures 21B et 21C expliquent comment calculer la position de cette fibre neutre en considérant le principe de la section transformée. Puis, en connaissant la position de cette fibre neutre et en utilisant l'équation (4), on peut en déduire la contrainte moyenne dans le Si.

La section transformée est définie par :

$$I_2 = I_1 E_{Si} / E_{SiN}$$

Et

$$C = (c_1(t_1 l_1) + c_2(t_2 l_2)) / (t_1 l_1) + (t_2 l_2)$$

Avec $c_1 = t_1/2$ et $c_2 = t_2/2$.

Le moment quadratique de la structure équivalente est donné par l'expression suivante :

$$I = I_1 + I_2 + (t_1 l_1)(\frac{t_1}{2} - c)^2 + (t_2 l_2)(t_1 + \frac{t_2}{2} - c)^2 \text{ avec } I_{1,2} = \frac{t_{1,2}^3 l_{1,2}}{12} \qquad (5)$$

Finalement, la contrainte moyenne dans une section en x (coordonnée longitudinale) de Si est :

$$\overline{\sigma}_L(x) = \frac{M(x)}{2I}(t_1 + t_2 - 2c) \qquad (6)$$

Lorsque l'épaisseur du silicium est négligeable devant celle du SiN (cas favorable) la contrainte dans le Si est en première approximation la contrainte appliquée sur la fibre la plus externe du SiN, en considérant que la fibre neutre est donnée par $c_1$ :

$$\sigma_L(x) = \frac{M(x)t_1}{2I} \text{ avec } I \equiv I_1 \qquad (7)$$

Pour obtenir la contrainte moyenne le long de la partie Si constituant le fil, il faut intégrer (6) ou (7) sur la longueur de le fil en considérant la déformée.

En sachant que :

$$EI\frac{\partial^2 y(x)}{\partial x^2} = M(x) \qquad (8)$$

En considérant une jauge de dimension z, l'expression (7) se réduit à :

$$\sigma_L(x) = \frac{Et_1}{2}\int_0^z \frac{\partial^2 y(x)}{\partial x^2}dx \qquad (9)$$

Finalement, la variation de résistance s'exprime comme suit :

$$\frac{dR}{R} = \frac{d\rho}{\rho} = \frac{\Pi_{44}}{2}\frac{Et_1}{2}\int_0^z \frac{\partial^2 y(x)}{\partial x^2}dx = G\frac{t_1}{2}\int_0^z \frac{\partial^2 y(x)}{\partial x^2}dx = G\varepsilon_L$$

$\varepsilon_L$ est l'allongement de la jauge, G est le facteur de jauge (de l'ordre de plusieurs milliers (par exemple pour un nanofil Si dopé au Bore à $10^{15}.cm^{-3}$).

Dans le cas du second mode de réalisation selon l'invention, on exploite directement l'élongation de la structure. L'origine de la variation est différente mais le calcul est identique :

$$\frac{dR}{R} \approx \varepsilon_L(1 + 2\nu) \approx G\varepsilon_L$$

G est de l'ordre de l'unité à quelques unités (typiquement 2 pour les métaux).

On voit que, dans les deux cas, la variation de résistivité est à l'ordre 1.

Dans un nanofil selon l'invention, quel que soit le mode de réalisation considéré, la dissymétrie créée du fait des différentes conductivités électriques permet de générer des contraintes différentes au-dessus et au-dessous de la fibre neutre. Ces contraintes ne s'équilibrent pas et ce déséquilibre permet d'obtenir une mesure au premier ordre.

On va maintenant décrire des procédés de réalisation de dispositifs selon invention.

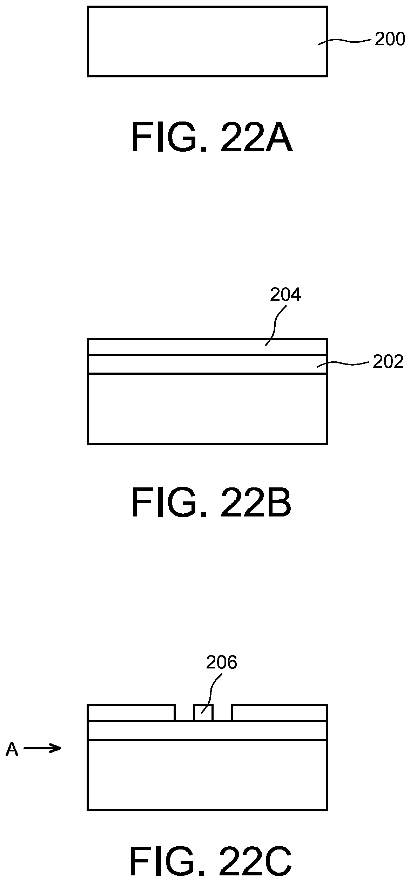

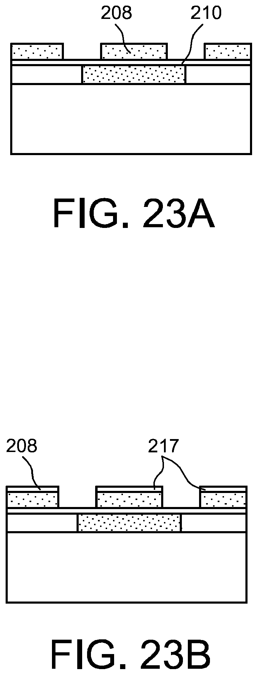

Une réalisation de fils présentant des matériaux différents selon l'épaisseur est décrite dans le document FR 2 884 648. Cette technique met en œuvre des étapes de lithographie et gravure. Deux exemples de réalisation vont être donnés, en liaison avec les figures 22A - 22L et 23A - 23E, respectivement pour une transduction « piézorésistive » avec une couche isolante et pour une transduction utilisant un métal.

On va d'abord décrire l'enchaînement des étapes des figures 22A - 22L, qui concerne la réalisation d'un seul nanofil, mais qui peut être aisément appliqué à la réalisation d'une pluralité de nanofils.

Dans une première étape, une plaquette de silicium 200 est sélectionnée.

Puis (figure 22B) on réalise deux épitaxies successivement d'une couche 202 en SiGe et d'une couche 204 en Si. La proportion de germanium dans la couche 202 SiGe peut être fixée à une valeur donnée ; elle peut aussi être variable dans cette couche, ce qui y induit une variation de la contrainte initiale. On peut donc régler cette contrainte initiale par contrôle de la proportion de germanium.

On procède ensuite (figure 22C) à une lithographie puis à une gravure de la couche 204 de silicium, pour former une nano poutre 206, dont les dimensions dans une section transversale sont par exemple de l'ordre de 50 nm x 50 nm.

Dans ce mode de réalisation on peut structurer une électrode d'actionnement.

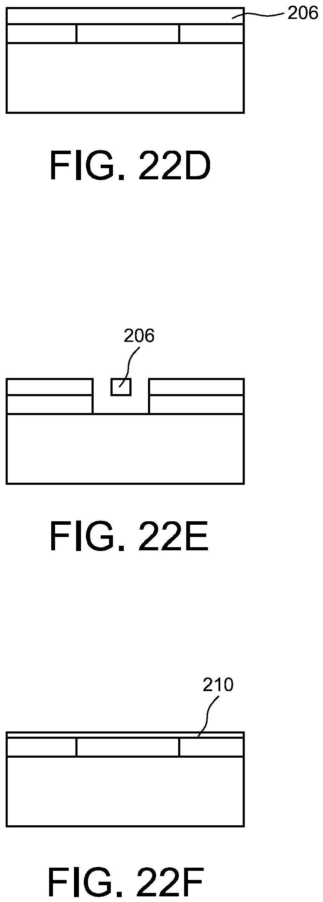

On libère ensuite cette nanopoutre par gravure tunnel de la couche de SiGe 204, ce qui est illustré, selon deux vues, en figures 22D et 22E. La vue de la figure 22E est une vue de côté selon la flèche A de la figure 22C.

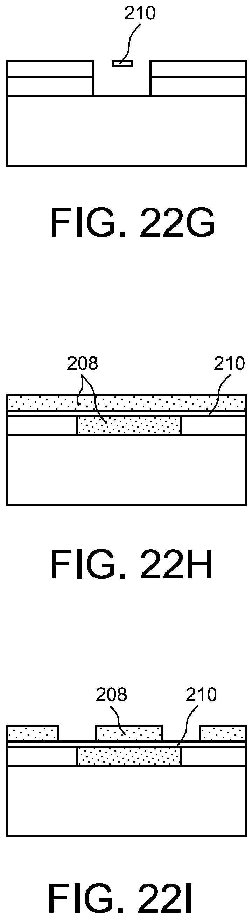

On procède ensuite à une réduction de la section de la nanopoutre pour former un ou des nanofils 210 (figures 22F et 22G, respectivement à partir des figures 22D et 22E), jusqu'à ce que ceux-ci atteignent un diamètre ou une dimension, selon une section, de l'ordre de 25 nm ou, plus généralement, comprise entre 10 et 30 nm.

Il est ensuite procédé (figure 22H) et à un dépôt d'oxyde 208, qui englobe l'ensemble du nanofil, 210, et qui remplit notamment le gap entre le nanofil et le substrat mais qui est également déposé au-dessus du nanofil.

Le dépôt d'oxyde réalisé au-dessus du nanofils peut ensuite subir des opérations de lithographie et de gravure (figure 22I), afin de dégager des zones d'accès au nanofil en vue d'en transformer certaines zones sélectionnées.

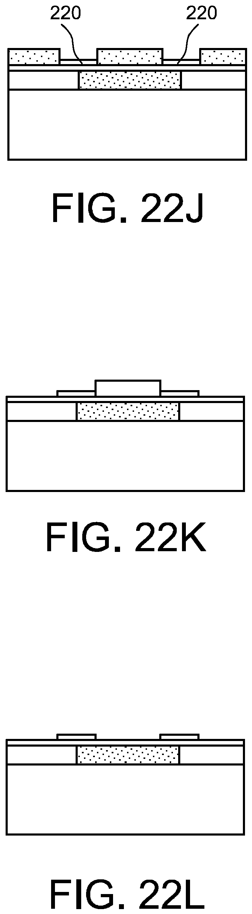

On peut alors procéder (figure 22J) à une nitruration 220 des portions dégagées du nanofil, sur une épaisseur de 10 nm par exemple, la technique utilisée pouvant être une technique de recuit qui n'induit pas de réaction dans l'oxyde.

Puis (figure 22K) l'oxyde 208 au dessus du fil est retiré ; le retrait du SiN sur l'oxyde peut être réalisé par voie humide. Eventuellement, on peut épaissir les zones de contact et les rendre métalliques par dopage et/ou siliciuration et/ou métallisation.

Enfin, le nanofil est libéré, par gravure de l'oxyde 208 disposé dans la cavité en contact avec le substrat (figure 22L).

Les deux premières étapes de ce procédé peuvent être supprimées en utilisant une plaque SOI. Dans ce cas on réalise une gravure de l'oxyde à la place de la gravure de la couche SiGe. La libération (figure 22D) se fait alors par voie HF vapeur.

On décrit maintenant l'enchaînement des étapes des figures 23A - 23E, qui concerne également la réalisation d'un seul nanofil, mais qui peut être aisément appliqué à la réalisation d'une pluralité de nanofils. On rappelle qu'il s'agit ici de la réalisation d'une transduction « piézométallique ».

Les figures du début du procédé sont identiques aux figures 22A-22I décrites ci-dessus. Elles n'ont donc pas été reproduites. La description faite ci-dessus en liaison avec ces figures reste valable.

On part donc d'une structure telle que celle de la figure 22I, reproduite en figure 23A.

On réalise ensuite un dépôt 217 de métal (nickel ou platine) sur l'ensemble des zones (figure 23B) .

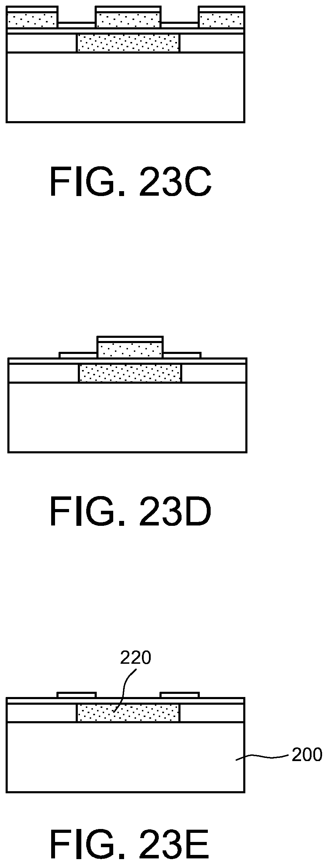

On peut alors procéder (figure 23C) à une siliciuration en diffusant le métal des portions dégagées du nanofil, sur une épaisseur de 6 nm par exemple. La technique utilisée est une technique de recuit qui n'induit pas de réaction dans l'oxyde. Le procédé de silicuration peut être remplacé par un dopage (jusqu'à l'amorphisation) .

Puis (figure 23D) l'oxyde 208 est retiré au dessus du nanofil; le retrait du NiSi sur l'oxyde peut être réalisé par voie humide. Enfin, le nanofil est libéré, par gravure de l'oxyde disposé dans la cavité 220 en contact avec le substrat 200 (figure 23E).

Là encore, les deux premières étapes peuvent être supprimées en utilisant une plaque SOI. La libération se fait alors, là aussi, par voie HF vapeur.

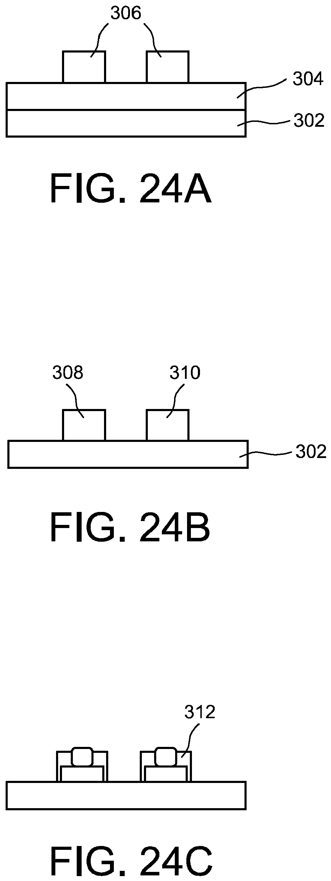

Un autre exemple de réalisation d'un procédé pour réaliser un dispositif selon l'invention va être donné, en liaison avec les figures 24A - 24E

Dans une première étape, une bicouche constituée d'une couche 302 de SiO2 ou de SiGe ou de Si et d'une couche 304 de SiGe ou de Si est réalisée (figure 24A). Une couche de résine peut être fo-rmée au dessus de cette bicouche puis gravée pour y former des motifs 306 qui vont permettre une gravure de la couche 302 (figure 24B).

Un recuit permet éventuellement d'arrondir les sommets des plots 308, 310 de Si ainsi réalisés. En variante, une succession d'étapes de recuit et/ou d'oxydation peuvent être réalisées afin d'arrondir et de réduire la section du nanofil. Une ou plusieurs étapes de recuit et/ou d'oxydation permet d'arrondir les nanofils, d'où une réduction de la section de ces nanofils, à un diamètre d'environ 5 nm par exemple. Une recristallisation peut être obtenue par recuit.

On réalise ensuite un dépôt et une gravure d'un masque 312 (espaceur) en SiO2 ou en SiN ou bicouche.

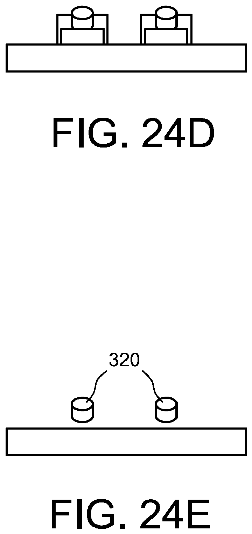

On procède ensuite à une siliciuration 320, comme décrit précédemment et à un retrait sélectif, respectivement du nickel, du platine, du cobalt,... (figure 24D). On siliciure les parties non protégées par l'espaceur 312.

Enfin (figure 24E) on procède à une gravure, au HF pur du SiO2, par plasma CF4 sous l'oxygène pour SiGe. On libère ainsi des nanofils 320 ayant la structure selon la présente invention.

Dans un dispositif selon l'invention, les moyens de mesure peuvent être réalisés par un circuit externe.

L'actionnement, par exemple électrostatique, est réalisé par l'intermédiaire d'un gap entre le substrat et le nanofil après libération du nanofil. Il est préférentiellement réalisé en gravant un gap «latéral » entre le nanofil et une électrode, pendant l'étape de gravure pour définir la nanofil.

Selon une variante de réalisation, le nanofil peut être mis en vibration par l'utilisation de moyens d'actionnement comportant une électrode latérale et une électrode sous le nanofil.

Un capteur selon l'invention peut être utilisé en tant que capteur chimique (une telle application avec un autre capteur est décrite dans Y. Wims et al. « Sensors and Actuators » B 108 (2005)), en phase gazeuse ou en phase liquide ou en tant que capteurs de force moléculaire (une telle application avec un autre capteur est décrite dans J.L. Arlett et al. « Nobel Symposium », 131 (2006)), ou encore dans le domaine de la spectrométrie de masse (une telle application avec un autre capteur est décrite dans W. Jensen et al. « Nature Nanotechnology » 9, 533 (2008)).

L'invention permet notamment de réaliser un capteur à base de nanofil avec au moins deux parties ou zones de conductivités très différentes, selon au moins deux approches :

- soit un nanofil métal/semi-conducteur par exemple obtenu par un procédé de microélectronique pour obtenir la couche conductrice et par une ou plusieurs des étapes décrites ci-dessus (par Siliciuration d'une partie du nanofil (peu ou pas dopé) ou par dopage (allant jusqu'à l'amorphisation éventuellement) d'une partie du fil),
- soit par nitruration d'au moins une partie d'un fil dopé.

En outre une ou des zones sensibles (telles que la ou les jauges piézorésistives) peuvent être localisées, d'où une amélioration de l'efficacité de transduction.

Dans tous les cas, il est possible de réaliser une amélioration de la prise de contact, du fait d'une résistance d'accès très faible, notamment par dopage de zones de contact.

Dans un dispositif selon l'invention, on obtient un effet du premier ordre dans le semi-conducteur, d'où un effet de détection accru par rapport aux techniques connues, notamment décrites dans le document WO 2005/106417.

## Revendications

1. Dispositif capteur, de type à nanofil, comportant :

    - au moins un nanofil (33, 33', 35, 35'), comportant une première zone (2), conductrice, et une deuxième zone (4, 4'), en matériau isolant, cette deuxième zone n'occupant pas toute l'épaisseur du nanofil, et un courant pouvant circuler dans ce dernier depuis l'une de ses extrémités à l'autre ;
    - au moins une masse (30, 37) mobile fixée à l'une des extrémités du nanofil.

2. Dispositif selon la revendication 1 comportant au moins une zone de maintien fixe (6, 6') à une extrémité du nanofil, cette zone de maintien comportant en outre une zone de contact électrique (8, 8').

3. Dispositif selon la revendication 2, au moins une zone de contact électrique étant réalisée dans le même matériau conducteur que la première zone (2), conductrice, du nanofil.

4. Dispositif selon l'une des revendications 1 à 3, comportant au moins deux nanofils (2, 2', 33 33', 35, 35'), tous deux fixés à la masse mobile, l'autre extrémité de chaque nanofil pouvant être fixée à une zone commune de maintien (6, 6'), fixe.

5. Dispositif selon la revendication 4, une extrémité de chaque nanofil étant fixée à ladite zone commune de maintien (6, 6'), fixe, par des zones conductrices (8, 8', 18, 18').

6. Dispositif selon l'une des revendications 1 à 5, la masse mobile comportant une partie centrale (30) formant une masse vibrante hors de son plan.

7. Dispositif selon l'une des revendications 1 à 6, dans lequel la masse mobile est au moins en partie conductrice et réalise une boucle de courant.

8. Dispositif selon l'une des revendications 1 à 7, dans lequel la masse mobile contient une portion diélectrique (34) sur toute son épaisseur, cette portion diélectrique séparant le dispositif en deux parties (30, 30') latérales, chacune de ces parties formant une zone de mesure avec 2 nanofils (33, 33', 35, 35') qui lui sont reliés.

9. Dispositif selon la revendication 8, dans lequel ladite portion diélectrique (34) se prolonge par des zones diélectriques latérales (34',34") chacune d'épaisseur inférieure à ladite portion diélectrique centrale (34).

10. Dispositif selon la revendication 9, dans lequel lesdites zones diélectriques latérales (34', 34") sont disposées en continuité du matériau isolant (4, 4') des nanofils.

11. Dispositif selon l'une des revendications 1 à 10, la deuxième zone du nanofil s'étendant sur une longueur inférieure à celle du nanofil.

12. Dispositif selon l'une des revendications précédentes, la partie conductrice du nanofil étant :

- en matériau semiconducteur dopé, par exemple en un matériau piézorésistif, le semi-conducteur pouvant être dopé avec de l'arsenic, ou du bore, ou du phosphore ;
- ou en matériau métallique, par exemple en un métal siliciuré, tel que du NiSi ou du WSi ou du PtSi.

13. dispositif selon l'une des revendications 1 à 12, le matériau isolant du nanofil étant un matériau diélectrique, par exemple en nitrure de silicium ou d'aluminium ou en oxyde de silicium, ou un matériau semi-conducteur intrinsèque, par exemple du silicium ou un alliage de silicium et de Germanium (SiGe), non dopés.

14. Dispositif selon l'une des revendications 1 à 13, le nanofil comportant :

- une zone diélectrique (4) en SiGe non dopé, et une zone (2) conductrice en Si dopé,
- ou une zone diélectrique (4) en Si non dopé, et une zone (2) conductrice en SiGe dopé.

15. Dispositif selon l'une des revendications 1 à 14, comportant en outre :

- des moyens de transduction traduisant, en signal électrique, des mouvements d'au moins un nanofil ou d'au moins ladite masse mobile (30, 37) fixée à l'une des extrémités du nanofil ;
- et/ou des moyens d'actionnement d'un nanofil de ce dispositif, ces moyens d'actionnement étant par exemple de type électrostatique ou de type thermoélastique ou de type magnétique.

**Patentansprüche**

1. Sensorvorrichtung vom Typ mit Nanodraht, enthaltend:

- mindestens einen Nanodraht (33, 33', 35, 35'), der eine erste leitende Zone (2) und eine zweite Zone (4, 4') aus isolierendem Material umfasst, wobei diese zweite Zone nicht die gesamte Dicke des Nanodrahts einnimmt und ein Strom durch diesen von einem seiner Enden zum anderen fließen kann;
- mindestens eine bewegliche Masse (30, 37), die an einem Ende des Nanodrahtes befestigt ist.

2. Vorrichtung nach Anspruch 1, enthaltend mindestens eine feste Haltezone (6, 6') an einem Ende des Nanodrahtes, wobei diese Haltezone ferner eine elektrische Kontaktzone umfasst (8, 8').

3. Vorrichtung nach Anspruch 2, wobei mindestens eine elektrische Kontaktzone aus dem gleichen leitenden Material wie die erste leitende Zone (2) des Nanodrahtes hergestellt ist.

4. Vorrichtung nach einem der Ansprüche 1 bis 3, enthaltend mindestens zwei Nanodrähte (2, 2', 33, 33', 35, 35'), die beide an der beweglichen Masse befestigt sind, wobei das andere Ende jedes Nanodrahtes an einer gemeinsamen festen Haltezone (6, 6') befestigt sein kann.

5. Vorrichtung nach Anspruch 4, wobei ein Ende eines jeden Nanodrahts über leitende Zonen (8, 8', 18, 18') an der gemeinsamen festen Haltezone (6, 6') befestigt ist.

6. Vorrichtung nach einem der Ansprüche 1 bis 5, wobei die bewegliche Masse einen Mittelabschnitt (30) enthält, der eine aus ihrer Ebene heraus schwingende Masse bildet.

7. Vorrichtung nach einem der Ansprüche 1 bis 6, wobei die bewegliche Masse zumindest teilweise leitend ist und eine Stromschleife bildet.

8. Vorrichtung nach einem der Ansprüche 1 bis 7, wobei die bewegliche Masse über ihre gesamte Dicke einen dielektrischen Abschnitt (34) enthält, wobei dieser dielektrische Abschnitt die Vorrichtung in zwei seitliche Abschnitte (30, 30') teilt, wobei jeder dieser Abschnitte eine Messzone mit 2 an diesen angeschlossenen Nanodrähten (33, 33', 35, 35') bildet.

9. Vorrichtung nach Anspruch 8, wobei der dielektrische Abschnitt (34) sich in seitlichen dielektrischen Zonen (34', 34") fortsetzt, die jeweils eine geringere Dicke als der dielektrische Mittelabschnitt (34) haben.

10. Vorrichtung nach Anspruch 9, wobei die seitlichen dielektrischen Zonen (34', 34") in Kontinuität mit dem Isoliermaterial (4, 4') der Nanodrähte angeordnet sind.

11. Vorrichtung nach einem der Ansprüche 1 bis 10, wobei die zweite Zone des Nanodrahts sich über eine Länge erstreckt, die geringer als die des Nanodrahts ist.

12. Vorrichtung nach einem der vorangehenden Ansprüche, wobei der leitende Abschnitt des Nanodrahts:

   - aus einem dotierten Halbleitermaterial, beispielsweise aus einem piezoresistiven Material, besteht, wobei der Halbleiter mit Arsen, Bor oder Phosphor dotiert sein kann;
   - oder aus einem metallischen Material, beispielsweise aus einem Silicid-Metall, wie etwa NiSi oder WSi oder PtSi, besteht.

13. Vorrichtung nach einem der Ansprüche 1 bis 12, wobei das Isoliermaterial des Nanodrahtes ein dielektrisches Material, beispielsweise aus Silizium- oder Aluminiumnitrid oder aus Siliciumoxid, oder ein intrinsisches Halbleitermaterial, beispielsweise Silizium oder eine Legierung aus Silizium und Germanium (SiGe), die undotiert sind, ist.

14. Vorrichtung nach einem der Ansprüche 1 bis 13, wobei der Nanodraht enthält:

   - eine dielektrische Zone (4) aus undotiertem SiGe und eine leitende Zone (2) aus dotiertem Si,
   - oder eine dielektrische Zone (4) aus undotiertem Si und eine leitende Zone (2) aus dotiertem SiGe.

15. Vorrichtung nach einem der Ansprüche 1 bis 14, ferner enthaltend:

   - Wandlerelemente, die Bewegungen von mindestens einem Nanodraht oder mindestens der beweglichen Masse (30, 37), die an einem der Enden des Nanodrahts befestigt ist, in ein elektrisches Signal umsetzen;
   - und/oder Mittel zur Betätigung eines Nanodrahtes dieser Vorrichtung, wobei diese Betätigungsmittel beispielsweise vom elektrostatischen Typ oder vom thermoelastischen Typ oder vom magnetischen Typ sind.

**Claims**

1. Sensor device, of nanowire type, comprising:

   - at least one nanowire (33, 33', 35, 35') comprising a first conductive region (2), and a second region (4, 4') in insulator material, this second region not occupying the entire thickness of the nanowire, a current being able to circulate in the nanowire from one of its ends to the other;
   - at least one mobile mass (30, 37) attached to one of the ends of the nanowire.

2. Device according to claim 1, comprising at least one fixed anchor region (6, 6') at one end of the nanowire, this anchor region further comprising an electric contact region (8, 8').

3. Device according to claim 2, at least one electric contact region being made in the same conductive material as the first conductive region (2) of the nanowire.

4. Device according to any of claims 1 to 3, comprising at least two nanowires (2, 2', 33, 33', 35, 35'), both attached to the mobile mass, the other end of each nanowire being able to be attached to a common anchor region (6, 6') that is fixed.

5. Device according to claim 4, one end of each nanowire being fixed to said fixed common anchor region (6, 6') via conductive regions (8, 8', 18, 18').

6. Device according to any of claims 1 to 5, the mobile mass comprising a central part (30), forming a mass vibrating outside its plane.

7. Device according to any of claims 1 to 6, wherein the mobile mass is at least partly conductive and allows a current loop to be obtained.

8. Device according to any of claims 1 to 7, wherein the mobile mass contains a dielectric portion (34), over its entire thickness, this dielectric portion separating the device into two lateral parts (30', 30"), each of these parts forming a measurement region with 2 nanowires (33, 33', 35, 35') connected to it.

9. Device according to claim 8, wherein said dielectric portion (34) is extended by lateral dielectric regions (34', 34"), each of narrower thickness than said central dielectric portion (34).

10. Device according to claim 9, wherein said lateral dielectric regions (34', 34") are arranged in the continuity of the dielectric regions (4, 4') of the nanowires.

11. Device according to any of claims 1 to 10, the second region of the nanowire extending over a length shorter than that of the nanowire.

12. Device according to any of the preceding claims, the conductive part of the nanowire being:

   - in doped semiconductor material, for example in piezoresistive material, the semiconductor being able to be doped with arsenic, boron or phosphorus;
   - or in metallic material, for example in a silicided metal, e.g. in NiSi or WSi or PtSi.

13. Device according to any of claims 1 to 12, the insulator material of the nanowire being a dielectric material, for example in silicon or aluminium nitride, or in silicon oxide or an intrinsic semiconductor material, for example silicon or an alloy of silicon and Germanium (SiGe), non-doped.

14. Device according to any of claims 1 to 13, the nanowire comprising:

   - a dielectric region (4) in non-doped SiGe, and a conductive region (2) in doped Si,
   - or a dielectric region (4) in non-doped Si and a conductive region (2) in doped SiGe.

15. Device according to any of claims 1 to 14, further comprising:

   - transduction means translating into an electric signal the motion of at least one nanowire or of at least one mobile mass (30, 37) attached to one of the ends of the nanowire;
   - and/or means to actuate a nanowire of this device, said means to actuate being for example of electrostatic type or of thermoelastic type or of magnetic type.

FIG. 1

FIG. 2

FIG. 3

FIG. 4A

FIG. 4B

FIG. 5A

FIG. 5B

FIG. 6A

FIG. 6B

FIG. 7A

FIG. 7B

FIG. 8A

FIG. 8B

FIG. 10A

FIG. 10B

FIG. 9A

FIG. 9B

FIG. 9C

FIG. 11A

FIG. 11B

FIG. 12A

FIG. 12B

**FIG. 13**

**FIG. 14**

FIG. 15

FIG. 16

FIG. 17

## FIG. 18

## FIG. 19

FIG. 20

FIG. 21A

FIG. 21B

FIG. 21C

FIG. 22A

FIG. 22B

FIG. 22C

206

**FIG. 22D**

206

**FIG. 22E**

210

**FIG. 22F**

210

**FIG. 22G**

208          210

**FIG. 22H**

208          210

**FIG. 22I**

220          220

## FIG. 22J

## FIG. 22K

## FIG. 22L

208    210

## FIG. 23A

208    217

## FIG. 23B

FIG. 23C

FIG. 23D

FIG. 23E

306

304

302

FIG. 24A

308          310

302

FIG. 24B

312

FIG. 24C

FIG. 24D

320

FIG. 24E

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005106417 A
- WO 2008017090 A2
- FR 2884648

**Littérature non-brevet citée dans la description**

- **M. ROUKES.** *Nanoletters,* 2008, vol. 8 (6), 1756-1761
- **I. BARGATIN et al.** *Applied Physics Letters,* 2005, vol. 86, 133109
- **Y. WIMS et al.** *Sensors and Actuators,* 2005, vol. B, 108
- **J.L. ARLETT et al.** *Nobel Symposium,* 2006, vol. 131
- **W. JENSEN et al.** *Nature Nanotechnology,* 2008, vol. 9, 533